# EUROPÄISCHE PATENTSCHRIFT

(11) **EP 2 740 335 B1**
(45) Veröffentlichungstag und Bekanntmachung des Hinweises auf die Patenterteilung: **30.12.2015**
(21) Anmeldenummer: 12746047.5
(22) Anmeldetag: 24.07.2012
(51) Int. Cl.: H05K 5/00, H05K 7/14

(54) **BEDIENTERMINAL**
OPERATOR CONTROL TERMINAL
TERMINAL DE COMMANDE

(30) Priorität: 03.08.2011 DE 102011109576
(43) Veröffentlichungstag der Anmeldung: 11.06.2014
(73) Patentinhaber: Pilz GmbH & Co. KG, 73760 Ostfildern (DE)
(72) Erfinder: SCHURR, Daniel, 73760 Ostfildern (DE); ZELL, Christoph, 73760 Ostfildern (DE); RINK, Joachim, 73760 Ostfildern (DE)
(74) Vertreter: Witte, Weller & Partner Patentanwälte mbB
(86) Internationale Anmeldenummer: PCT/EP2012/064450
(87) Internationale Veröffentlichungsnummer: WO 2013/017468

(56) Entgegenhaltungen:
- WO-A1-95/05062
- WO-A1-03/001798
- WO-A1-2008/143321
- US-B1- 7 188 400

## Beschreibung

Die vorliegende Erfindung betrifft einen Bedienschrank mit einem Bedienterminal zum Bedienen einer technischen Anlage gemäß dem Oberbegriff von Anspruch 1. Ein gattungsgemäßes Bedienterminal ist in WO 2008/143321 A1 offenbart.

Unter Bedienterminal zum Bedienen einer technischen Anlage im Sinne der vorliegenden Erfindung ist ein Bedienterminal zu verstehen, das geeignet ist, mindestens einen Zustand der technischen Anlage anzuzeigen (z.B. für Diagnose), damit ein Benutzer die technische Anlage entsprechend bedienen kann (z.B. durch Betätigen eines (Not-Aus-)Schalters). Zusätzlich kann das Bedienterminal auch geeignet sein zum Empfangen einer Eingabe eines Bedienbefehls, mittels dessen der Benutzer die technische Anlage bedienen bzw. manuell steuern kann.

Ein Bedienterminal dieser Art ist beispielsweise ein Bedienterminal, wie es die Anmelderin der vorliegenden Erfindung unter dem Namen PIPANEL-Monitor vertreibt bzw. vertrieben hat. Wie beispielsweise aus der Beschreibung "Pilz, Industriecomputer, Bedienungsanleitung, PIPANEL-Monitor, Sach-Nr. 19 557" bekannt, müssen für den Einbau Montagelöcher für Befestigungsbolzen in die Wand gebohrt werden. Diese Montagelöcher müssen an genau definierten Positionen (mit geringer Toleranz) gebohrt werden. Ein derartiges bekanntes Bedienterminal erfordert daher eine relativ aufwendige Montage bzw. Einbau in den Ausschnitt der Wand, insbesondere präzise Bohrungen und daher hohe Montagezeit.

Ein Bedienterminal dieser Art kann weiterhin beispielsweise ein Bedienterminal sein, wie es die Anmelderin der vorliegenden Erfindung unter dem Namen PMI® vertreibt. Wie beispielsweise aus der Beschreibung "Pilz, PMIvisu/PMIopen IV, Bedienterminals, Bedienungsanleitung, Sach-Nr. 21 897-01" bekannt, kann das Bedienterminal mit Hilfe von mehreren Befestigungsblechen und Linsenkopfschrauben in den Ausschnitt der Wand eingebaut werden (insbesondere bei dem Modell PMI 426/431/438). Jedes der Befestigungsbleche ist mit Schrauben an dem Gehäuse des Bedienterminals befestigt. Jeweils eine der Linsenkopfschrauben wird durch eines der Befestigungsbleche derart angeordnet, dass die Linsenkopfschraube gegen die Rückseite der Wand drückt. Für die Montage eines solchen Bedienterminals werden daher viele Teile benötigt. Auch dieses bekannte Bedienterminal erfordert somit eine relativ aufwendige Montage bzw. Einbau in den Ausschnitt der Wand.

WO 95/05062 offenbart ein Bedienterminal, das wahlweise als Handheld-Gerät oder als in einer Schranktür eingebautes Gerät betrieben werden kann. Das Bedienterminal besitzt ein Gehäuse mit einem umlaufenden Rand, der etwas größer ist als ein etwaiger Wandausschnitt für die Montage. Des Weiteren besitzt das Bedienterminal eine becherartig ausgeführte Gehäuserückwand, die von der Rückseite der Wand her auf das Gehäusevorderteil aufgesetzt und mit diesem verschraubt werden kann. Wie in der bildlichen Darstellung der einzigen Figur erkennbar ist, müssen dazu Bolzen bzw. Gewindeschrauben von der Gehäuserückseite her durch die Gehäuserückwand eingeführt und mit dem Gehäusevorderteil verschraubt werden.

US 7,188,400 B1 offenbart einen Montagerahmen für elektronische Baugruppen inklusive einer Anzeigeeinheit.

Vor diesem Hintergrund ist es eine Aufgabe der vorliegenden Erfindung, ein Bedienterminal und einen Bedienschrank der eingangs genannten Art anzugeben, die eine einfachere Montage bzw. einen einfacheren Einbau in den Ausschnitt der Wand bereitstellen.

Gemäß einem ersten Aspekt der Erfindung wird diese Aufgabe durch einen Bedienschrank mit Bedienterminal gemäß Anspruch 1 gelöst.

Das Bedienterminal verwendet also eine Platte mit einer Mehrzahl von Löchern, in die (im eingebauten Zustand) jeweils ein entsprechender Bolzen eingreifen kann. Insbesondere ist jedes Loch derart angeordnet und ausgebildet, dass der entsprechende Bolzen eingreifen kann. Ein Bolzen kann hier ein langgestrecktes Element sein, insbesondere ein Element mit einer Länge, die sehr viel größer ist als sein Durchmesser oder seine Breite. Jeder Bolzen ist mit seinem ersten Ende auf dem Rahmen angeordnet und erstreckt sich im eingebauten Zustand mit seinem zweiten Ende durch den Ausschnitt hindurch. Jeder Bolzen erstreckt sich somit im eingebauten Zustand durch den Ausschnitt oder ist darin angeordnet. Jedes Loch in der Platte ist an einer dem entsprechenden Bolzen entsprechenden Position angeordnet. Die Löcher sind insbesondere jeweils auf einer Fläche der Platte angeordnet, die sich im eingebauten Zustand innerhalb des Ausschnitts der Wand befindet (in einer Draufsicht auf das Bedienterminal gesehen bzw. in einer Ebene parallel zu einer durch die Wand definierten Wandebene). Die Platte ragt insbesondere derart in den Ausschnitt der Wand hinein, dass jeweils einer der Bolzen in ein entsprechendes Loch der Platte eingreifen kann. Die Bolzen sind insbesondere jeweils (mit dem ersten Ende) auf einer Fläche des Rahmens angeordnet, die sich im eingebauten Zustand innerhalb des Ausschnitts der Wand befindet (in einer Draufsicht auf das Bedienterminal gesehen bzw. in einer Ebene parallel zu einer durch die Wand definierten Wandebene). Die Bolzen erstrecken sich insbesondere jeweils (mit dem zweiten Ende) in eine Richtung, die senkrecht zu einer durch die Wand definierten Ebene verläuft. Jeder Bolzen kann insbesondere eine Länge (in Richtung senkrecht zur Wandebene) haben, die sich im eingebauten Zustand mit dem zweiten (hinausragenden) Ende über die Platte hinaus erstreckt. Um das Bedienterminal sichernd an der Wand zu befestigen, kann das Bedienterminal insbesondere eine Mehrzahl von Sicherungsmittel umfassen, wobei auf jeden der Bolzen (bzw. auf das zweite Ende) ein Sicherungsmittel aufgesetzt werden kann bzw. im eingebauten Zustand aufgesetzt ist.

Da jeder Bolzen mit seinem ersten Ende in dem Rahmen befestigt und in das Bedienterminal integriert ist (bzw. integraler Bestandteil des Rahmens ist), wird ein kompaktes Bedienterminal bereitgestellt. Dadurch, dass die Bolzen in dem Rahmen befestigt sind, müssen Bolzen nicht als separate Teile mitgeliefert werden. Es werden daher nur wenige separate Teile für den Einbau benötigt.

Für den Einbau in den Ausschnitt der Wand wird das Bedienterminal in einem ersten Schritt in dem Ausschnitt der Wand angeordnet (mit dem transparenten Element und dem Rahmen auf der Vorderseite der Wand). In einem zweiten Schritt wird die Platte auf der Rückseite der Wand angeordnet, wobei jeder Bolzen in ein entsprechendes Loch eingreift. In einem dritten Schritt wird jeweils ein entsprechendes Sicherungsmittel (beispielsweise eine Mutter) auf jeweils einen Bolzen aufgesetzt, um das Bedienterminal an der Wand sichernd zu befestigen.

Die Montage bzw. der Einbau ist somit relativ einfach. Es müssen keine Bohrungen in der Wand vorgesehen werden und es werden nur wenige Teile für den Einbau benötigt. Des Weiteren wird eine optimale Dichtung zwischen Bedienterminal und Wand erreicht. Die oben genannte Aufgabe ist daher vollständig gelöst.

In einer Ausgestaltung befindet sich die Rahmenauflagefläche in einem Bereich zwischen dem äußeren Rahmenrand und dem inneren Rand des Ausschnitts, und/oder die Plattenauflagefläche befindet sich in einem Bereich zwischen dem äußeren Plattenrand und dem inneren Rand des Ausschnitts. In einer Variante kann jeder Bolzen auf einer Fläche des Rahmens angeordnet sein, die von der Rahmenauflagefläche umgeben ist, und/oder jedes Loch kann auf einer Fläche der Platte angeordnet sein, die von der Plattenauflagefläche umgeben ist.

In dieser Ausgestaltung werden die Plattenauflagefläche und die Rahmenauflagefläche genauer definiert. Die Plattenauflagefläche ist definiert zwischen dem äußeren Plattenrand und dem inneren Rand des Ausschnitts. Die Rahmenauflagefläche ist definiert zwischen dem äußeren Rahmenrand und dem inneren Rand des Ausschnitts. Insbesondere kann die Platte mit der Plattenauflagefläche die Rückseite der Wand berühren oder dieser gegenüber liegen. Auch der Rahmen kann insbesondere mit der Rahmenauflagefläche die Vorderseite der Wand berühren oder dieser gegenüber liegen. Die Löcher können auf einer Fläche der Platte angeordnet sein, die von der Plattenauflagefläche umgeben ist (Fläche innerhalb der Plattenauflagefläche), insbesondere in einer zu einer durch die Wand definierten Wandebene parallelen Ebene. Die Bolzen können (mit dem ersten Ende) auf einer Fläche des Rahmens angeordnet sein, die von der Rahmenauflagefläche umgeben ist (Fläche innerhalb der Rahmenauflagefläche), insbesondere in einer zur Wandebene parallelen Ebene. Beispielsweise im Fall eines viereckigen Rahmens bzw. Ausschnitts können die Löcher auf einer von einer viereckigen ringförmigen Plattenauflagefläche umschlossenen Fläche angeordnet sein und/oder die Bolzen können auf einer von einer viereckigen ringförmigen Rahmenauflagefläche umschlossenen Fläche angeordnet sein.

In einer bevorzugten Ausgestaltung weist das Bedienterminal eine Mehrzahl von selbstsichernden elastischen Muttern auf. In einer Variante kann jede selbstsichernde elastische Mutter mit einem Gewinde versehen sein und/oder jeder Bolzen kann ein gewindebehafteter (mit einem entsprechenden Gegengewinde versehender) Bolzen sein. Alternativ kann der Bolzen ein gewindeloser Bolzen sein. Auf jeden Bolzen kann jeweils eine Mutter aufgesetzt werden, um das Bedienterminal an der Wand sichernd zu befestigen.

In dieser Ausgestaltung wird eine besonders einfache und schnelle sichernde Befestigung des Bedienterminals an der Wand bereitgestellt. Das Sicherungsmittel wird hier in Form einer selbstsichernden elastischen Mutter bereitgestellt. Die selbstsichernde elastische Mutter kann beispielsweise eine unter dem Namen SERPRESS bekannte Mutter sein. Eine selbstsichernde elastische Mutter kann ohne Werkzeug, nur von Hand, (mit nur geringer Anzugskraft) montiert werden. Aufgrund ihrer Elastizität kann sich die selbstsichernde elastische Mutter bei Ausüben der Anzugskraft verformen bzw. verspannen. Die selbstsichernde elastische Mutter kann sich derart verspannen, dass eine hohe Haltekraft ausgeübt wird (selbstsichernd). Die selbstsichernde elastische Mutter kann dabei direkt auf der Platte aufliegen. Es sind somit keine Unterlegscheiben erforderlich, wodurch wiederum weniger Teile zur Montage benötigt werden.

In einer alternativen Ausgestaltung weist das Bedienterminal eine Mehrzahl von konventionellen, jeweils mit einem Gewinde versehenen Muttern auf. In einer Variante kann jeder Bolzen ein gewindebehafteter (mit einem entsprechenden Gegengewinde versehener) Bolzen sein. Auf jeden Bolzen kann jeweils eine Mutter aufgesetzt werden, um das Bedienterminal an der Wand sichernd zu befestigen.

In dieser Ausgestaltung wird eine kostengünstige sichernde Befestigung des Bedienterminals an der Wand bereitgestellt, da konventionelle Muttern verwendet werden, die kostengünstiger sind. Das Sicherungsmittel wird hier somit in Form einer konventionellen Mutter bereitgestellt.

In einer weiteren Ausgestaltung sind die Bolzen auf einer Fläche des Rahmens angeordnet, die das transparente Element umgibt.

In dieser Ausgestaltung wir erreicht, dass der durch das transparente Element sichtbare Bereich des Displays nicht gestört wird. Die Bolzen sind jeweils auf einer Fläche (in einer zu der Wandebene parallelen Ebene) des Rahmens außerhalb des transparenten Elementes angeordnet.

In einer weiteren Ausgestaltung weist der Rahmen eine viereckige Form mit vier Eckbereichen und vier dazwischen liegenden Seiten auf, und zumindest in jedem Eckbereich ist ein Bolzen angeordnet.

In dieser Ausgestaltung wird durch das Vorsehen der Bolzen in den vier Eckbereichen eine einfache, aber wirkungsvolle Art des Einbaus bereitgestellt. Zudem wird eine ausreichende Dichtung zwischen dem Bedienterminal und der Wand erreicht.

In einer weiteren Ausgestaltung ist auf jeder Seite mindestens ein weiterer Bolzen angeordnet ist.

In dieser Ausgestaltung wird eine noch bessere sichernde Befestigung des Bedienterminals an der Wand bereitgestellt. Zudem wird die Dichtung weiterhin verbessert.

In einer weiteren Ausgestaltung erstreckt sich die Platte über den gesamten Umfang des Ausschnitts der Wand.

In dieser Ausgestaltung wird eine gleichmäßige Kraftverteilung über den gesamten Umfang (Gesamtumfang) des Ausschnitts bereitgestellt. Es wird so eine optimale Dichtung zwischen dem Bedienterminal und der Wand erreicht. Zudem sind hohe Anpresskräfte bei der sichernden Befestigung des Bedienterminals an der Wand möglich, ohne dass sich die Platte verformt bzw. verformen kann.

In einer alternativen Ausgestaltung kann sich die Platte auch nur über einen wesentlichen Teil des Umfangs des Ausschnitts der Wand erstrecken.

In dieser Ausgestaltung wird ebenfalls eine gleichmäßige Kraftverteilung erreicht, jedoch mit weniger Material für die Platte. Der wesentliche Teil des Umfangs kann insbesondere im Bereich zwischen 50% und 100%, insbesondere 80% und 100%, des Gesamtumfangs des Ausschnitts der Wand betragen.

In einer weiteren Ausgestaltung ist die Platte einteilig ausgebildet.

In dieser Ausgestaltung werden nur wenige Teile für den Einbau benötigt. Diese Ausgestaltung kann insbesondere in Kombination mit der vorhergehenden Ausgestaltung verwendet werden.

In einer alternativen Ausgestaltung ist die Platte mindestens zweiteilig ausgebildet.

In dieser Ausgestaltung wird bei größerer Dimension bzw. Abmessung des Bedienterminals und/oder des Ausschnitts eine einfachere Handhabung bei der Montage bereitgestellt. Im Gegensatz zu einer großen einteiligen Platte, werden dann mindestens zwei, insbesondere genau zwei, kleinere Teile der Platte vorgesehen, die besser handhabbar sind. Die mindestens zwei Teile der Platte können im eingebauten Zustand insbesondere aneinander angrenzen.

In einer weiteren Ausgestaltung umfasst das Bedienterminal eine Displayelektronik zum Ansteuern des Displays und ein Gehäuse, in dem die Displayelektronik angeordnet ist.

In dieser Ausgestaltung wird die Displayelektronik zum Ansteuern des Displays durch das Gehäuse geschützt.

In einer weiteren Ausgestaltung erstreckt sich das Gehäuse in einen an die Rückseite der Wand angrenzenden Raum hinein.

In dieser Ausgestaltung wird ausreichend Platz für das Anordnen der Displayelektronik in dem Gehäuse bereitgestellt. Das Gehäuse erstreckt sich insbesondere in einer Rechtung senkrecht zur Wandebene in den an die Rückseite angrenzenden Raum (Rückraum) hinein.

In einer weiteren Ausgestaltung weist die Platte weiterhin eine Aussparung auf, innerhalb derer das Gehäuse im eingebauten Zustand angeordnet werden kann.

In dieser Ausgestaltung wird erreicht, dass (auf die Rückseite der Wand blickend bzw. vom Rückraum aus) ein wesentlicher Teil des Ausschnitts bzw. des Bedienterminals durch die Platte verdeckt ist, ausgenommen dem Teil, in dem das Gehäuse sich in den an die Rückseite der Wand angrenzenden Raum hineinerstreckt. Die Platte schützt somit das Bedienterminal von der Rückseite, während sich das Gehäuse in den an die Rückseite angrenzenden Raum erstrecken kann. Insbesondere kann die Aussparung einen inneren Plattenrand bilden. Der innere Plattenrand kann im eingebauten Zustand insbesondere bis an das Gehäuse heranreichen bzw. in einem geringen Abstand davon angeordnet sein.

In einer weiteren Ausgestaltung umfasst die Displayelektronik einen Sensorsignaleingang zum Empfangen eines Sensorsignals von einem Sensor, einen Prozessor zum Erzeugen eines Steuerungssignals durch Verarbeiten des Sensorsignals, und einen Steuerungssignalausgang zum Übermitteln des Steuerungssignals an einen Aktor der technischen Anlage.

In dieser Ausgestaltung ist das Bedienterminal bzw. die Displayelektronik nicht nur zum Anzeigen geeignet, sondern auch zur automatisierten Steuerung der technischen Anlage. Die Displayelektronik bildet hier zusätzlich eine Steuerungsvorrichtung zum automatisierten Steuern der technischen Anlage.

In einer alternativen Ausgestaltung ist eine Steuerungsvorrichtung zum automatisierten Steuern der technischen Anlage in dem Bedienschrank vorgesehen, wobei die Steuerungsvorrichtung einen Sensoreingang zum Empfangen eines Sensorsignals von einem Sensor, einen Prozessor zum Erzeugen eines Steuerungssignals durch Verarbeiten des Sensorsignals, und einen Steuerungssignalausgang zum Übermitteln des Steuerungssignals an einen Aktor der technischen Anlage umfasst.

In dieser Ausgestaltung umfasst der Bedienschrank neben dem Bedienterminal auch eine Steuerungsvorrichtung zum automatisierten Steuern der technischen Anlage.

In einer weiteren Ausgestaltung ist ein Bedienterminal vorgesehen, wobei das transparente Element eine Touchscreenelektronik umfasst zum Erzeugen eines durch Berührung des transparenten Elements erzeugten Eingabesignals.

In dieser Ausgestaltung ist das Bedienterminal auch zum Empfangen einer Eingabe eines Bedienbefehls geeignet. Es wird ein Touchscreenbereich bereitgestellt, um den Bedienbefehl durch Berühren des transparenten Elements einzugeben.

In einer weiteren Ausgestaltung umfasst die Displayelektronik einen Eingabesignaleingang zum Empfangen eines bzw. des Eingabesignals, das einer Eingabe eines Bedienbefehls zum Steuern der technischen Anlage entspricht, und einen Eingabesignalausgang zum Übermitteln des Eingabesignals an die technische Anlage.

In dieser Ausgestaltung wird durch Eingabe eines Bedienbefehls, insbesondere eine Eingabe auf dem Touchscreenbereich der vorhergehenden Ausgestaltung, eine manuelle Steuerung der technischen Anlage bereitgestellt.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in den Zeichnungen dargestellt und werden in der nachfolgenden Beschreibung näher erläutert. Es zeigen:
- Fig. 1: eine vereinfachte Darstellung eines Ausführungsbeispiels des neuen Bedienterminals mit technischer Anlage,
- Fig. 2: eine perspektivische Explosionsansicht eines Ausführungsbeispiels des neuen Bedienterminals,
- Fig. 3: eine perspektivische Ansicht des Ausführungsbeispiels des Bedienterminals der Fig. 2 im eingebauten Zustand,
- Fig. 4: eine Querschnittsansicht des in Fig. 2 und Fig. 3 gezeigten Ausführungsbeispiels des Bedienterminals,
- Fig. 5: eine Draufsicht auf die Rückseite des Ausführungsbeispiels der Fig. 2 bis 4 des Bedienterminals, und
- Fig. 6: einen vergrößerten Ausschnitt der Fig. 5.

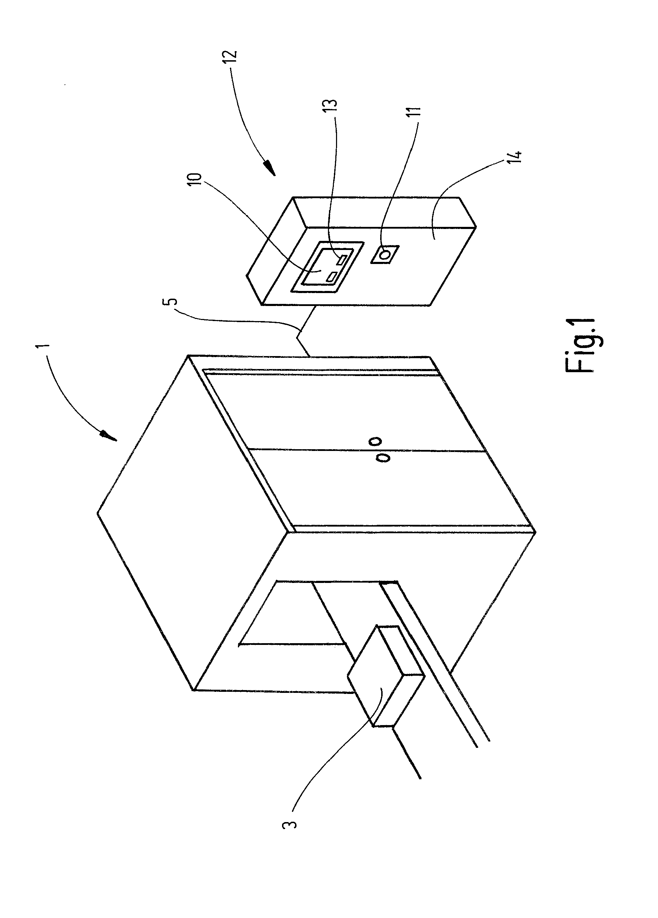

Fig. 1 zeigt eine vereinfachte Darstellung eines Ausführungsbeispiels des neuen Bedienterminals 10 mit technischer Anlage 1. Im Ausführungsbeispiel der Fig. 1 ist die technische Anlage in einem Schutzraum angeordnet und dient zum Bearbeiten einer Ware 3. Ein Signal, das den Zustand der technischen Anlage 1 angibt, (z.B. Diagnosesignal) kann über eine Leitung 5 zwischen der technischen Anlage 1 und dem Bedienterminal 10 übertragen werden. Das Bedienterminal 10 umfasst ein Display zum Anzeigen des mindestens einen Zustands der technischen Anlage 1 entsprechend dem über die Leitung 5 übermittelten Signals. Das Display zeigt den Zustand der technischen Anlage 1 an (z.B. für Diagnose), damit ein Benutzer die technische Anlage 1 entsprechend bedienen kann, beispielsweise durch Betätigen eines (Not-Aus-)Schalters 11, wie in Fig. 1 dargestellt. Zusätzlich kann das Bedienterminal 10 auch geeignet sein zum Empfangen einer Eingabe eines Bedienbefehls mittels dessen der Benutzer die technische Anlage 1 bedienen bzw. manuell steuern kann. Dies kann beispielsweise mit Hilfe eines Touchscreens realisiert werden. Hierzu kann das Display mindestens einen virtuellen Schalter 13 an einer vorbestimmten Position anzeigen, wobei durch Berühren der vorbestimmten Position ein entsprechendes Eingabesignal erzeugt wird, welches über die Leitung 5 an die technische Anlage 1 übermittelt wird.

Das Bedienterminal 10 zum Bedienen der technischen Anlage 1 ist in einem eingebauten Zustand (wie in Fig. 1 dargestellt) in einen mit einem inneren Rand versehenen Ausschnitt einer Wand 14 mit einer Vorderseite und einer Rückseite eingebaut. Durch die Wand 14 ist eine Wandebene E definiert. Durch die Wand 14 ist weiterhin ein an die Rückseite 18 der Wand 14 angrenzender Raum definiert (Rückraum), und ein an die Vorderseite 17 der Wand 14 angrenzender Raum (Vorderraum). Wie in Fig. 1 zu sehen ist das Bedienterminal 10 von dem an die Vorderseite der Wand 14 angrenzenden Raum (Vorderraum) aus bedienbar. Das in Fig. 1 gezeigte Bedienterminal ist in einem Bedienschrank 12 zum Bedienen der technischen Anlage 1 angeordnet. Die Wand 14 ist eine Wand des Bedienschranks 12. Der Bedienschrank kann beispielweise ein Schaltschrank, Schaltpult, Rack, oder ähnliches sein.

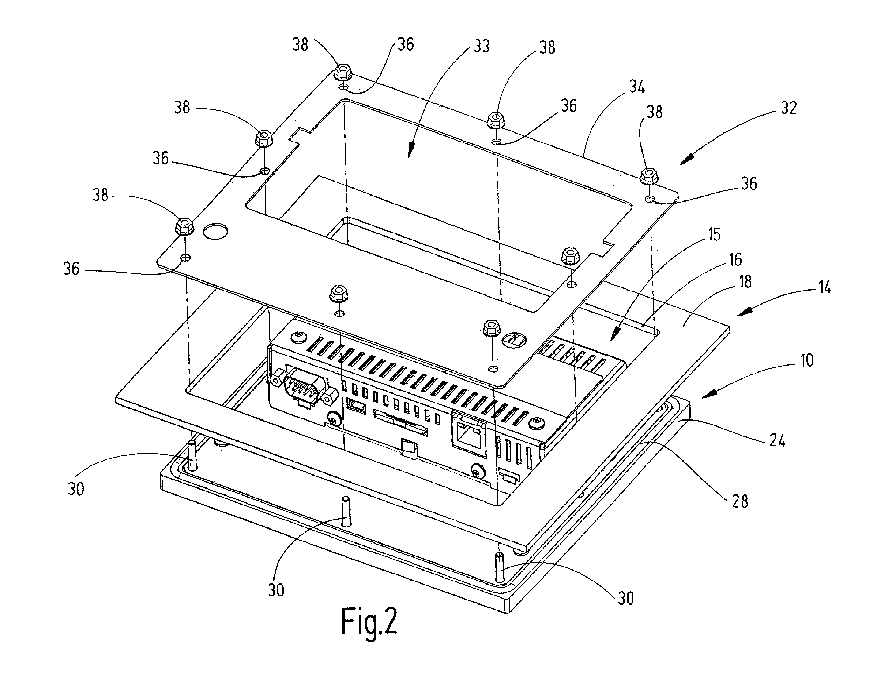

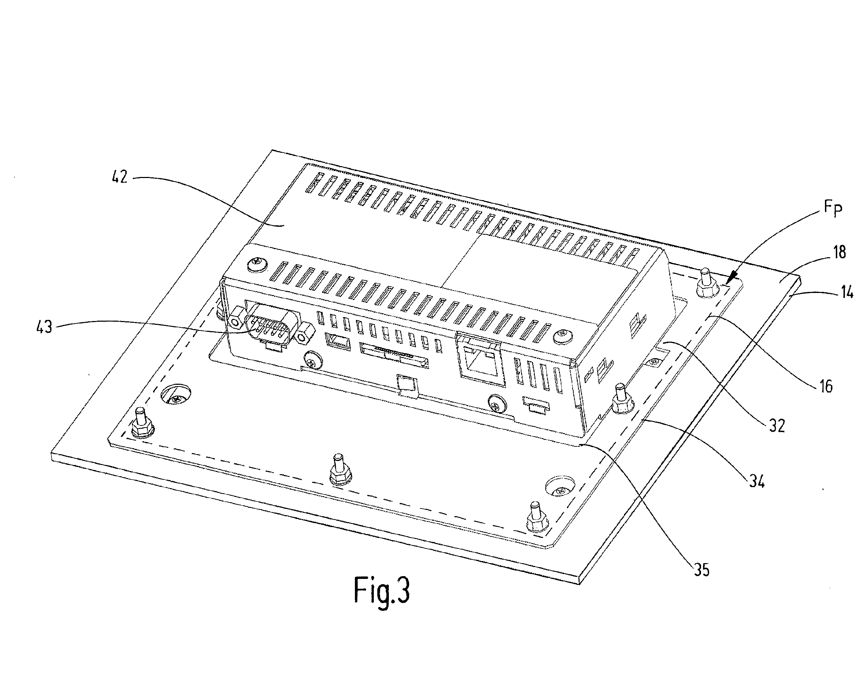

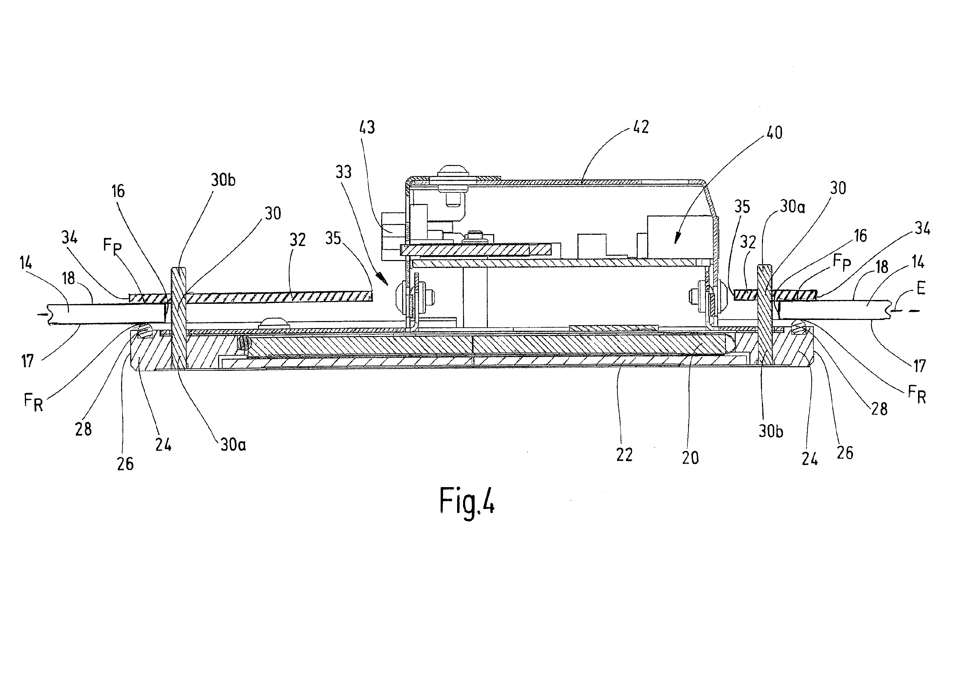

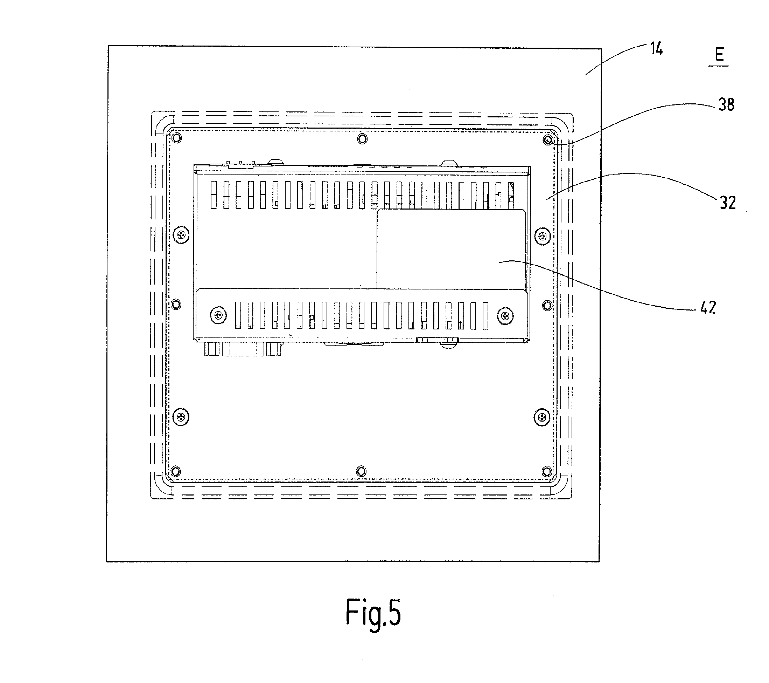

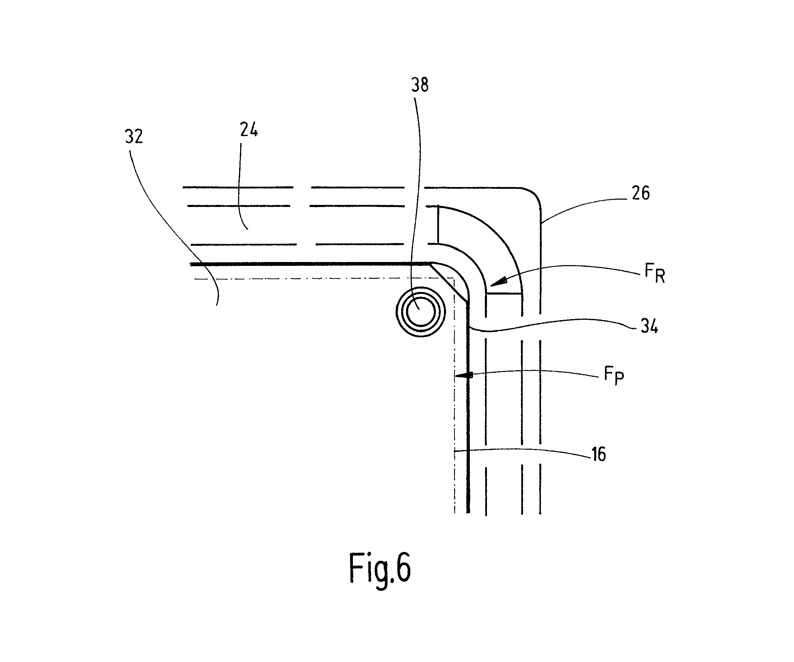

Fig. 2 zeigt eine perspektivische Explosionsansicht eines Ausführungsbeispiels des neuen Bedienterminals 10, und Fig. 3 zeigt eine entsprechende perspektivische Ansicht des Ausführungsbeispiels des Bedienterminals im eingebauten Zustand. Fig. 4 zeigt eine entsprechende Querschnittsansicht des Ausführungsbeispiels des Bedienterminals. Fig. 5 zeigt eine entsprechende Draufsicht auf die Rückseite des Ausführungsbeispiels des Bedienterminals, und Fig. 6 einen vergrößerten Ausschnitt der Fig. 5. In Fig. 3, Fig. 5 und Fig. 6 sind verdeckte Bereiche bzw. Kanten gestrichelt dargestellt.

Wie in Fig. 4 zu sehen, umfasst das Bedienterminal 10 ein transparentes Element 22, auf dem das Display 20 angeordnet ist. Das transparente Element 22 kann beispielsweise eine Platte aus Glas, Acrylglas, oder einem anderen geeigneten transparenten Material sein. Durch das transparente Element 22 wird ein sichtbarer Bereich des Displays 20 bereitgestellt. Das Display 20 umfasst hier Anzeigemittel oder Leuchtmittel für eine visuelle Anzeige. Das Display 20 kann beispielsweise ein LCD-Display, ein Plasma-Display, oder eine andere geeignete Art von Display sein.

Das transparente Element 22 umgibt ein Rahmen 24 mit einem äußeren Rahmenrand 26. In dem gezeigten Ausführungsbeispiel umgibt der Rahmen 24 auch das Display 20. Der Rahmen 24 kann beispielsweise aus einem Metall oder einem anderen geeigneten Material hergestellt sein. Das Bedienterminal 10 umfasst weiterhin eine Mehrzahl von Bolzen 30 mit jeweils einem ersten Ende 30a und einem zweiten Ende 30b. In dem hier gezeigten Ausführungsbeispiel ist jeder Bolzen 30 ein langgestrecktes Element mit rundem Querschnitt. Jeder Bolzen 30 ist mit seinem ersten Ende 30a auf dem Rahmen 24 angeordnet bzw. befestigt. Jeder Bolzen 30 erstreckt sich im eingebauten Zustand mit seinem zweiten Ende 30b durch den Ausschnitt 15 der Wand 14 hindurch. In dem gezeigten Ausführungsbeispiel erstrecken sich die Bolzen 30 jeweils (mit dem zweiten Ende) in eine Richtung, die senkrecht zur Wandebene verläuft. Jeder Bolzen 30 hat eine Länge (in Richtung senkrecht zur Wandebene E), die sich im eingebauten Zustand mit dem zweiten (hinausragenden) Ende über die Platte 32 hinaus erstreckt.

Wie in Fig. 2 bis Fig. 6 zu sehen umfasst das Bedienterminal 10 weiterhin eine Platte 32 mit einem äußeren Plattenrand 34. Die Platte 32 kann beispielweise aus einem Metall (insbesondere Metallblech) oder anderen geeigneten Material hergestellt sein. Die Platte 32 weist eine Mehrzahl von Löchern 36 auf, wobei jedes Loch 36 an einer einem (entsprechenden) Bolzen 30 (der Mehrzahl von Bolzen) entsprechenden Position angeordnet ist, so dass im eingebauten Zustand der entsprechende Bolzen 30 darin eingreifen kann. Insbesondere ist jedes Loch 36 derart ausgebildet, dass der entsprechende Bolzen 30 passgenau darin eingreifen bzw. angeordnet werden kann.

Der äußere Rahmenrand 26 ist größer bemessen als der innere Rand 16 des Ausschnitts 15, so dass im eingebauten Zustand der Rahmen 24 mit einer Rahmenauflagefläche F_{R} auf der Vorderseite 17 der Wand 14 aufliegen kann. Der äußere Plattenrand 34 der Platte 32 ist größer bemessen als der innere Rand 16 des Ausschnitts 15, so dass im eingebauten Zustand die Platte 32 mit einer Plattenauflagefläche F_{P} auf der Rückseite 18 der Wand 14 aufliegen kann.

Die Löcher 36 sind auf einer Fläche der Platte 32 angeordnet, die sich im eingebauten Zustand innerhalb des Ausschnitts 15 der Wand 14 befindet (in einer Draufsicht auf das Bedienterminal 10 gesehen, wie in Fig. 5 gezeigt, bzw. in einer Ebene parallel zu der Wandebene E). Die Platte 32 ragt derart in den Ausschnitt 15 der Wand 14 hinein, dass jeweils einer der Bolzen 30 in ein entsprechendes Loch 36 der Platte 32 eingreifen kann. Die Bolzen 30 sind auf einer Fläche des Rahmens 24 angeordnet, die sich im eingebauten Zustand innerhalb des Ausschnitts 15 der Wand 14 befindet (in einer Draufsicht auf das Bedienterminal 10 gesehen, wie in Fig. 5 gezeigt, bzw. in einer Ebene parallel zur Wandebene E).

Die Rahmenauflagefläche F_{R} befindet sich in einem Bereich zwischen dem äußeren Rahmenrand 26 und dem inneren Rand 16 des Ausschnitts 15. In dem gezeigten Ausführungsbeispiel umfasst der Rahmen 24 einen Dichtungsring 28. Im eingebauten Zustand berührt in diesem Ausführungsbeispiel nur der Dichtungsring 28 die Vorderseite 17 der Wand 14. Es sollte jedoch verstanden werden, dass die Rahmenauflagefläche F_{R} dennoch in dem gesamten Bereich zwischen dem äußeren Rahmenrand 26 und dem inneren Rand 16 des Ausschnitts 15 definiert ist. Der Rahmen 24 berührt daher mit der Rahmenauflagefläche F_{R} die Vorderseite 17 der Wand 14 auf oder liegt mit der Rahmenauflagefläche F_{R} der Vorderseite 17 der Wand 14 gegenüber. Jeder Bolzen 30 ist auf einer Fläche des Rahmens 24 angeordnet, die von der Rahmenauflagefläche F_{R} umgeben ist (innerhalb der Rahmenauflagefläche), wie beispielsweise in Fig. 6 zu sehen. In diesem Ausführungsbeispiel ist die Rahmenauflagefläche eine viereckige ringförmige Rahmenauflagefläche. Jeder Bolzen ist daher auf einer von der viereckigen ringförmigen Rahmenauflagefläche F_{R} umschlossenen Fläche angeordnet.

Die Plattenauflagefläche F_{P} befindet sich in einem Bereich zwischen dem äußeren Plattenrand 34 und dem inneren Rand 16 des Ausschnitts 15. In dem gezeigten Ausführungsbeispiel liegt die Platte mit der gesamten Plattenauflagefläche F_{P} auf der Rückseite 18 der Wand 14 auf. Die Platte 32 ragt in den Ausschnitt 15 hinein. Die Platte 32 ragt insbesondere derart in den Ausschnitt der Wand 14 hinein, dass jeweils einer der Bolzen 30 in ein entsprechendes Loch 36 der Platte eingreifen kann. Jedes Loch 36 ist auf einer Fläche der Platte 32 angeordnet, die von der Plattenauflagefläche F_{P} umgeben ist (innerhalb der Plattenauflagefläche). Die Plattenauflagefläche ist in dem gezeigten Ausführungsbeispiel eine viereckige ringförmige Plattenauflagefläche F_{P}. Daher ist jedes der Löcher auf einer von der viereckigen ringförmigen Plattenauflagefläche F_{P} umschlossenen Fläche angeordnet.

Um das Bedienterminal sichernd an der Wand zu befestigen, umfasst das Bedienterminal 10 eine Mehrzahl von Sicherungsmittel, in diesem Ausführungsbeispiel Muttern 38, wobei auf jeden Bolzen 30 (bzw. auf sein zweites Ende 30b) ein Sicherungsmittel aufgesetzt werden kann bzw. im eingebauten Zustand aufgesetzt wird. Das Sicherungsmittel wird somit auf das zweite (hinausragende) Ende 30b des Bolzens 30 aufgesetzt und somit sichernd befestigt.

In Bezug auf Fig. 2 wird nun der Einbau des Bedienterminals 10 in den Ausschnitt 15 der Wand 14 beschrieben. In einem ersten Schritt wird das Bedienterminal 10 in dem Ausschnitt 15 der Wand 14 angeordnet, mit dem transparenten Element 22 und dem Rahmen 24 auf der Vorderseite 17 der Wand 14 (Fronteinbau), parallel zur Wandebene E. In einem zweiten Schritt wird die Platte 32 auf der Rückseite 18 der Wand 14 angeordnet, parallel zur Wandebene E, wobei jeder Bolzen 30 in ein entsprechendes Loch 36 der Platte 32 eingreift. In einem dritten Schritt wird jeweils ein entsprechendes Sicherungsmittel, in diesem Ausführungsbeispiel eine Mutter 38, auf jeweils einen Bolzen 30 aufgesetzt (bzw. auf sein zweites Ende 30b), um das Bedienterminal 10 an der Wand 14 sichernd zu befestigen.

In dem gezeigten Ausführungsbeispiel sind die Sicherungsmittel eine Mehrzahl von selbstsichernden elastischen Muttern 38. Jede selbstsichernde elastische Mutter 38 ist mit einem Gewinde versehen sein. Jeder Bolzen 30 ist ein gewindebehafteter (mit einem entsprechenden Gegengewinde versehender) Bolzen. Auf jeden der Bolzen 30 wird jeweils eine der Mehrzahl von Muttern 38 aufgesetzt, um das Bedienterminal an der Wand 14 sichernd zu befestigen. Es sollte verstanden werden, dass jede andere geeignete Art von Sicherungsmitteln vorgesehen werden kann. Beispielsweise könnte jeder Bolzen 30 auch ein gewindeloser Bolzen (Bolzen ohne Gewinde bzw. Bolzen mit ebener oder glatter Oberfläche) sein. Beispielsweise könnten die Sicherungsmittel auch eine Mehrzahl von konventionellen, mit einem Gewinde versehenen Muttern sein. Auf jeden der mit dem Gegengewinde versehenen Bolzen kann jeweils eine Mutter mit dem Gewinde aufgesetzt bzw. aufgeschraubt werden, um das Bedienterminal an der Wand sichernd zu befestigen.

In dem gezeigten Ausführungsbeispiel weist der Rahmen 24 eine viereckige, hier rechteckige, Form mit vier Eckbereichen und vier dazwischen liegenden Seiten auf. In jedem Eckbereich ist ein Bolzen 30 angeordnet. Weiterhin ist auf jeder Seite ein weiterer Bolzen 30 angeordnet. Somit umfasst das Bedienterminal in dem gezeigten Ausführungsbeispiel acht Bolzen 30 und entsprechende acht Löcher 36. Es sollte jedoch verstanden werden, dass jede andere geeignete Anzahl von Löchern und Bolzen vorgesehen werden kann.

Das Bedienterminal 10 umfasst eine Displayelektronik 40 zum Ansteuern des Displays 20, wie beispielsweise in der Querschnittsansicht der Fig. 4 zu sehen. Die Displayelektronik 40 kann einen Prozessor zum Erzeugen eines Anzeigesignals zum Ansteuern des Displays 20 (bzw. der Anzeigemittel oder Leuchtmittel) umfassen. Auf dem Prozessor kann ein Betriebssystem, beispielsweise Windows CE oder ähnliches, implementiert sein. Das Bedienterminal 10 umfasst weiterhin ein Gehäuse 42, in dem die Displayelektronik 40 angeordnet ist. Das Gehäuse 42 erstreckt sich in einen an die Rückseite 18 der Wand 14 angrenzenden Raum (Rückraum) hinein, in eine Richtung senkrecht zur Wandebene E. Das Bedienterminal 10 des gezeigten Ausführungsbeispiels umfasst weiterhin ein E-/A-Teil 43, wie in Fig. 3 dargestellt, das elektrisch mit der Displayelektronik 40 verbunden ist. Das E-/A-Teil 43 ist hier an dem Gehäuse 42 angeordnet. Beispielweise kann das Signal, das den Zustand der Anlage 1 angibt, über das E-/A-Teil 40 an das Bedienterminal 10 übertragen werden. In Fig. 3 ist rein beispielhaft ein E-/A-Teil 43 gekennzeichnet. Es sollte verstanden, dass das E-/A-Teil 43 jede geeignete Art von E-/A-Teil mit Eingängen und/oder Ausgängen sein kann.

In dem gezeigten Ausführungsbeispiel erstreckt sich die Platte 32 über den gesamten Umfang des Ausschnitts 15 der Wand 14. Die Platte 32 ist hierbei einteilig ausgebildet. Die Platte 32 weist eine Aussparung 33 auf, innerhalb derer das Gehäuse 42 im eingebauten Zustand angeordnet werden kann. Es wird so erreicht, dass, von dem an die Rückseite 18 der Wand 14 angrenzenden Raum (Rückraum) aus gesehen, ein wesentlicher Teil des Ausschnitts 15 bzw. des Bedienterminals 10 durch die Platte 32 verdeckt ist, ausgenommen dem Teil, in dem das Gehäuse sich in den an die Rückseite 18 der Wand 14 angrenzenden Raum (Rückraum) hineinerstreckt. Die Platte 32 schützt somit das Bedienterminal 10 von der Rückseite bzw. zum Rückraum hin, während sich das Gehäuse in den Rückraum hinein erstrecken kann. Die Aussparung 33 bildet einen inneren Plattenrand 35. Der innere Plattenrand 35 ist in dem gezeigten Ausführungsbeispiel in einem geringen Abstand von dem Gehäuse 42 beabstandet, im eingebauten Zustand.

Obwohl die Platte 32 im gezeigten Ausführungsbeispiel einteilig ausgebildet ist, sollte verstanden werden, dass die Platte 32 alternativ auch mindestens zweiteilig ausgebildet sein kann, insbesondere bei größerer Dimension bzw. Abmessung des Bedienterminals 10 und/oder des Ausschnitts 14. Des Weiteren sollte verstanden werden, dass, obwohl die Platte 32 im gezeigten Ausführungsbeispiel sich über den gesamten Umfang des Ausschnitts 15 der Wand 14 erstreckt, die Platte alternativ auch nur über einen wesentlichen Teil des Umfangs des Ausschnitts 15 erstrecken kann. Der wesentliche Teil des Umfangs kann insbesondere im Bereich zwischen 50% und 100%, insbesondere 80% und 100%, des Gesamtumfangs des Ausschnitts 15 der Wand 14 betragen.

Das Bedienterminal 10 kann des Weiteren geeignet sein zum Empfangen einer Eingabe eines Bedienbefehls, mittels dessen der Benutzer die technische Anlage 1 bedienen bzw. manuell steuern kann. Hierzu kann das transparente Element 22 eine Touchscreenelektronik umfassen zum Erzeugen eines durch Berührung des transparenten Elements 22 erzeugten Eingabesignals, beispielsweise Berühren eines durch das Display 20 angezeigten virtuellen Schalters an einer vorbestimmten Position. Die Displayelektronik 40 kann dann einen Eingabesignaleingang zum Empfangen des durch Berührung des transparenten Elementes 22 erzeugten Eingabesignals umfassen, das eine Eingabe eines Bedienbefehls zum Steuern der technischen Anlage entspricht. Die Displayelektronik 40 kann weiterhin ein Eingabesignalausgang zum Übermitteln des Eingabesignals an die technische Anlage 1 umfassen. Beispielsweise kann das Eingabesignal über das E-/A-Teil 43 an die technische Anlage 1 übermittelt werden.

Das Bedienterminal kann weiterhin geeignet sein zum automatisierten Steuern der technischen Anlage 1, wie bereits in Bezug auf Fig. 1 beschrieben. Hierzu kann die Displayelektronik 40 einen Sensorsignaleingang zum Empfangen eines Sensorsignals von einem Sensor, einen Prozessor zum Erzeugen eines Steuerungssignals durch Verarbeiten des Sensorsignals, und einen Steuerungssignalausgang zum Übermitteln des Steuerungssignals an einen Aktor der technischen Anlage 1 umfassen. Der Prozessor kann derselbe Prozessor sein, der zum Erzeugen des Anzeigesignals verwendet wird.

## Patentansprüche

1. Bedienschrank (12) zum Bedienen einer technischen Anlage (1), mit einer Wand (14) mit einer Vorderseite (17), einer Rückseite (18) und mit einem Ausschnitt (15) mit einem inneren Rand (16), ferner mit einem Bedienterminal (10), das in den Ausschnitt (15) eingebaut ist, wobei das Bedienterminal (10) aufweist:
ein Display (20) zum Anzeigen mindestens eines Zustands der technischen Anlage (1), einen Rahmen (24) mit einem äußeren Rahmenrand (26), eine Mehrzahl von Bolzen (30) mit jeweils einem ersten Ende (30a) und einem zweiten Ende (30b), und eine Platte (32) mit einem äußeren Plattenrand (34), wobei der äußere Rahmenrand (26) größer bemessen ist als der innere Rand (16) des Ausschnitts (15), so dass im eingebauten Zustand der Rahmen (24) mit einer Rahmenauflagefläche (F_{R}) auf der Vorderseite (17) der Wand (14) aufliegen kann, wobei der äußere Plattenrand (34) größer bemessen ist als der innere Rand (15) des Ausschnitts (16), so dass im eingebauten Zustand die Platte (32) mit einer Plattenauflagefläche (F_{P}) auf der Rückseite (18) der Wand (14) aufliegen kann, wobei die Platte (32) eine Mehrzahl von Löchern (36) aufweist, wobei jedes Loch (36) an einer einem Bolzen (30) entsprechenden Position angeordnet ist, so dass im eingebauten Zustand der entsprechende Bolzen (30) darin eingreifen kann, wobei jeder Bolzen (30) mit seinem ersten Ende (30a) auf dem Rahmen (24) angeordnet ist, und wobei jeder Bolzen (30) sich im eingebauten Zustand mit seinem zweiten Ende (30b) durch den Ausschnitt (15) hindurch erstreckt,
**dadurch gekennzeichnet, dass** das Bedienterminal (10) ferner ein transparentes Element (22) aufweist, auf dem das Display (20) angeordnet ist, wobei der Rahmen (24) das transparente Element (22) umgibt, und wobei jeder Bolzen (30) durch einteiliges Ausbilden, eine Schweissverbindung oder eine Klebeverbindung mit seinem ersten Ende (30a) in dem Rahmen (24) befestigt ist und in das Bedienterminal (10) integriert ist.

2. Bedienschrank nach Anspruch 1, wobei sich die Rahmenauflagefläche (F_{R}) in einem Bereich zwischen dem äußeren Rahmenrand (26) und dem inneren Rand (16) des Ausschnitts (15) befindet, und/oder wobei sich die Plattenauflagefläche (F_{P}) in einem Bereich zwischen dem äußeren Plattenrand (34) und dem inneren Rand (16) des Ausschnitts (15) befindet.

3. Bedienschrank nach Anspruch 1 oder 2, mit einer Mehrzahl von selbstsichernden elastischen Muttern (38).

4. Bedienschrank nach einem der Ansprüche 1 bis 3, wobei der Rahmen (24) eine viereckige Form mit vier Eckbereichen und vier dazwischen liegenden Seiten aufweist, und wobei zumindest in jedem Eckbereich ein Bolzen (30) angeordnet ist.

5. Bedienschrank nach einem der Ansprüche 1 bis 4, wobei die Platte (32) sich über den gesamten Umfang des Ausschnitts (15) der Wand (14) erstreckt.

6. Bedienschrank nach einem der Ansprüche 1 bis 5, wobei die Platte (32) einteilig ausgebildet ist.

7. Bedienschrank nach einem der Ansprüche 1 bis 5, wobei die Platte (32) mindestens zweiteilig ausgebildet ist.

8. Bedienschrank nach einem der Ansprüche 1 bis 7, mit einer Displayelektronik (40) zum Ansteuern des Displays (20) und mit einem Gehäuse (42), in dem die Displayelektronik (40) angeordnet ist.

9. Bedienschrank nach Anspruch 8, wobei sich das Gehäuse (42) in einen an die Rückseite (18) der Wand (14) angrenzenden Raum hinein erstreckt.

10. Bedienschrank nach Anspruch 8 oder 9, wobei die Platte (32) weiterhin eine Aussparung (33) aufweist, innerhalb derer das Gehäuse (42) im eingebauten Zustand angeordnet werden kann.

11. Bedienschrank nach einem der Ansprüche 8 bis 10, die Displayelektronik (40) mit einem Sensorsignaleingang zum Empfangen eines Sensorsignals von einem Sensor, einem Prozessor zum Erzeugen eines Steuerungssignals durch Verarbeiten des Sensorsignals, und einem Steuerungssignalausgang zum Übermitteln des Steuerungssignals an einen Aktor der technischen Anlage (1).

12. Bedienschrank nach einem der Ansprüche 8 bis 11, die Displayelektronik (40) mit einem Eingabesignaleingang zum Empfangen eines Eingabesignals, das einer Eingabe eines Bedienbefehls zum Steuern der technischen Anlage entspricht, und mit einem Eingabesignalausgang zum Übermitteln des Eingabesignals an die technische Anlage (1).

13. Bedienschrank nach einem der Ansprüche 1 bis 12, wobei das transparente Element (22) eine Touchscreenelektronik umfasst zum Erzeugen eines durch Berührung des transparenten Elements (22) erzeugten Eingabesignals.

## Claims

1. An operator cabinet (12) for operating a technical system (1), the cabinet comprising a wall (14) having a front side (17), a rear side (18) and a cutout (15) provided with an inner edge (16), and further comprising an operator terminal (10) installed in the cutout (15), wherein the operator terminal comprises
a display (20) for displaying at least one state of the technical system (1), a frame (24) having an outer frame edge (26), a plurality of bolts (30) each having a first end (30a) and a second end (30b), and a plate (32) with an outer plate edge (34), the outer frame edge (26) being dimensioned so as to be larger than the inner edge (16) of the cutout (15), with the result that, when installed, the frame (24) can rest with a frame resting area (F_{R}) on the front side (17) of the wall (14), the outer plate edge (34) being dimensioned so as to be larger than the inner edge (15) of the cutout (16), with the result that, when installed, the plate (32) can rest with a plate resting area (F_{P}) on the rear side (18) of the wall (14), the plate (32) having a plurality of holes (36), each hole (36) being arranged in a position corresponding to one bolt (30), with the result that, when installed, the corresponding bolt (30) can engage in said hole, each bolt (30) being arranged with its first end (30a) on the frame (24), and each bolt (30) extending, when installed, with its second end (30b) through the cutout (15),
**characterized in that** the operator terminal (10) further comprises a transparent element (22) on which the display (20) is arranged, wherein the frame (24) surrounds the transparent element (22), and wherein each bolt (30) is fastened with its first end (30a) in the frame (24) and is integrated into the operator terminal (10) by means of an integral design, a welded joint or an adhesive bonding.

2. The operator cabinet according to Claim 1, wherein the frame resting area (F_{R}) is located in a region between the outer frame edge (26) and the inner edge (16) of the cutout (15), and/or wherein the plate resting area (F_{P}) is located in a region between the outer plate edge (34) and the inner edge (16) of the cutout (15).

3. The operator cabinet according to Claim 1 or 2, comprising a plurality of selfsecuring elastic nuts (38).

4. The operator cabinet according to one of Claims 1 to 3, wherein the frame (24) has a quadrilateral form with four corner regions and four sides therebetween, and wherein a bolt (30) is arranged at least in each corner region.

5. The operator cabinet according to one of Claims 1 to 4, wherein the plate (32) extends over the entire circumference of the cutout (15) in the wall (14).

6. The operator cabinet according to one of Claims 1 to 5, wherein the plate (32) is formed in one part.

7. The operator cabinet according to one of Claims 1 to 5, wherein the plate (32) is formed in at least two parts.

8. The operator cabinet according to one of Claims 1 to 7, comprising display electronics (40) for driving the display (20) and comprising a housing (42) in which the display electronics (40) are arranged.

9. The operator cabinet according to Claim 8, wherein the housing (42) extends into a space adjoining the rear side (18) of the wall (14).

10. The operator cabinet according to Claim 8 or 9, wherein the plate (32) furthermore has a recess (33), within which the housing (42) can be arranged, when installed.

11. The operator cabinet according to one of Claims 8 to 10, with the display electronics (40) comprising a sensor signal input for receiving a sensor signal from a sensor, a processor for generating a control signal in response to processing the sensor signal, and a control signal output for transmitting the control signal to an actuator of the technical system (1).

12. The operator cabinet according to one of Claims 8 to 11, with the display electronics (40) comprising a control signal input for receiving a control signal which corresponds to an input of an operating command for controlling the technical system, and comprising a control signal output for transmitting the control signal to the technical system (1).

13. The operator cabinet according to one of Claims 1 to 12, wherein the transparent element (22) comprises touchscreen electronics for generating a control signal by touching contact with the transparent element (22).

## Revendications

1. Armoire de commande (12) qui commande une installation technique (1) et qui présente une paroi (14) présentant une face avant (17), une face arrière (18) et une découpe (15) dotée d'un bord intérieur (16), un terminal de commande (10) étant en outre monté dans la découpe (15), le terminal de commande (10) présentant :
un affichage (20) qui affiche au moins un état de l'installation technique (1),
un encadrement (24) doté d'un bord extérieur d'encadrement (26),
plusieurs goujons (30) présentant chacun une première extrémité (30a) et une deuxième extrémité (30b) et
une plaque (32) dotée d'un bord extérieur de plaque (34),
le bord extérieur d'encadrement (26) ayant des dimensions plus grandes que le bord intérieur (16) de la découpe (15) de telle sorte qu'en position montée, l'encadrement (24) peut reposer par une surface (F_{R}) de pose d'encadrement sur la face avant (17) de la paroi (14),
le bord extérieur de plaque (34) présentant des dimensions plus grandes que le bord intérieur (15) de la découpe (16) de sorte qu'en position montée, la plaque (32) peut reposer par une surface (F_{P}) de pose de plaque sur la face arrière (18) de la paroi (14),
la plaque (32) présentant plusieurs trous (36), chaque trou (36) étant disposé en une position correspondant à celle d'un goujon (30) de telle sorte qu'en position montée, le goujon (30) correspondant peut s'y insérer,
chaque goujon (30) étant disposé avec sa première extrémité (30a) sur l'encadrement (24) et chaque goujon (30) s'étendant en position montée avec sa deuxième extrémité (30b) traversant la découpe (15),
**caractérisée en ce que**
le terminal de commande (10) présente en outre un élément transparent (22) sur lequel l'affichage (20) est disposé,
**en ce que** l'encadrement (24) entoure l'élément transparent (22),
**en ce que** chaque goujon (30) est fixé dans l'encadrement (24) et intégré dans le terminal de commande (10) en formant d'une seule pièce une liaison soudée ou une liaison collée avec sa première extrémité (30a).

2. Armoire de commande selon la revendication 1, dans laquelle la surface (F_{R}) de pose d'encadrement se trouve dans une partie située entre le bord extérieur d'encadrement (26) et le bord intérieur (16) de la découpe (15) et/ou dans lequel la surface (F_{P}) de pose de plaque se trouve dans une partie située entre le bord extérieur de plaque (34) et le bord intérieur (16) de la découpe (15).

3. Armoire de commande selon les revendications 1 ou 2, présentant plusieurs écrous élastiques (38) autobloquants.

4. Armoire de commande selon l'une des revendications 1 à 3, dans laquelle l'encadrement (24) présente la forme d'un quadrilatère présentant quatre parties de sommet entre lesquelles sont situés quatre côtés, au moins un goujon (30) étant disposé dans chaque partie de sommet.

5. Armoire de commande selon l'une des revendications 1 à 4, dans laquelle la plaque (32) s'étend sur toute la périphérie de la découpe (15) de la paroi (14).

6. Armoire de commande selon l'une des revendications 1 à 5, dans laquelle la plaque (32) est formée en une seule pièce.

7. Armoire de commande selon l'une des revendications 1 à 5, dans laquelle la plaque (32) est réalisée en au moins deux pièces.

8. Armoire de commande selon l'une des revendications 1 à 7, présentant une électronique d'affichage (40) qui commande l'affichage (20) et un boîtier (42) dans lequel l'électronique d'affichage (40) est disposée.

9. Armoire de commande selon la revendication 8, dans laquelle le boîtier (42) s'étend dans un espace adjacent à la face arrière (18) de la paroi (14).

10. Armoire de commande selon les revendications 8 ou 9, dans laquelle la planque (32) présente en outre une découpe (33) à l'intérieur de laquelle le boîtier (42) peut être disposé lorsqu'il est monté.

11. Armoire de commande selon l'une des revendications 8 à 10, dans laquelle l'électronique d'affichage (40) présente une entrée de signal de capteur qui reçoit le signal d'un capteur, un processeur qui forme un signal de commande par traitement du signal de capteur et une sortie de signal de commande qui transmet le signal de commande à un actionneur de l'installation technique (1).

12. Armoire de commande selon l'une des revendications 8 à 11, dans laquelle l'électronique d'affichage (40) présente une entrée de signal d'introduction qui reçoit un signal d'introduction, qui correspond à l'introduction d'un ordre de commande qui commande l'installation technique et une sortie de signal d'entrée qui transmet le signal d'entrée à l'installation technique (1).

13. Armoire de commande selon l'une des revendications 1 à 12, dans laquelle l'élément transparent (22) comporte une électronique d'écran tactile qui forme un signal d'entrée par contact avec l'élément transparent (22).
